(19) Europäisches Patentamt
European Patent Office
Office européen des brevets

(11) Publication number: **0 072 763**
**B1**

(12) **EUROPEAN PATENT SPECIFICATION**

(45) Date of publication of patent specification: **18.06.86**

(51) Int. Cl.$^4$: **G 11 C 11/40,** G 11 C 5/00

(21) Application number: **82401541.6**

(22) Date of filing: **17.08.82**

# (54) Semiconductor memory device.

(30) Priority: **19.08.81 JP 128803/81**

(43) Date of publication of application:
**23.02.83 Bulletin 83/08**

(45) Publication of the grant of the patent:
**18.06.86 Bulletin 86/25**

(84) Designated Contracting States:
**DE FR GB**

(56) References cited:
**EP-A-0 031 659**
**US-A-4 044 340**
**US-A-4 222 062**

(73) Proprietor: **FUJITSU LIMITED**
**1015, Kamikodanaka Nakahara-ku**
**Kawasaki-shi Kanagawa 211 (JP)**

(72) Inventor: **Higuchi, Mitsuo**
**5-13, Yutenji 2-chome**
**Meguro-ku Tokyo 153 (JP)**
Inventor: **Takeuchi, Atsuchi**
**440-1, Eda-cho Midori-ku**
**Yokohama-shi Kanagawa 227 (JP)**

(74) Representative: **Descourtieux, Philippe et al**
**CABINET BEAU de LOMENIE 55 rue d'Amsterdam**
**F-75008 Paris (FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 072 763 B1**

## Description

Background of the invention

Field of the invention

The present invention relates to a semiconductor memory device.

Generally, a semiconductor memory device comprises a word-line selecting and driving circuit (word drive circuit) for decoding word address signals to select a single word line and for driving the selected single word line, a bit-line selecting circuit for decoding bit address signals, a plurality of word lines connected to the outputs of the word-drive circuit, a plurality of bit lines connected to the outputs of the bit-line selecting circuit, and memory cells arranged on the intersections between the word lines and the bit lines.

The present invention more particularly relates to a semiconductor memory device in which the memory cell array can be miniaturized without the limitation of the space occupied by the word drive circuit.

Description of the prior art

Conventionally, the outputs of a word drive circuit are connected to the word lines in a one-to-one correspondence. Recent miniaturization of memory cells has led to an increasingly smaller space between adjacent word lines, however, this has made essential the miniaturization of the word drive circuit, integrated with the memory cell array on one chip, as well. The miniaturization of word drive circuits, however, is difficult.

As a result, the size of the word drive circuits has limited the degree to which memory cell arrays could be miniaturized. This has been especially true in an erasable programmable read only memory (EPROM) which has a complicated word drive circuit including high voltage driving circuits as well as row decoder circuits. Therefore, in conventional semiconductor memory devices, although the size of the memory cell arrays themselves could theoretically be miniaturized, the degree of their miniaturization has been limited by the size of the word drive circuits. As a result, the total size of semiconductor memory devices could not be miniaturized that much.

To achieve some miniaturization of semiconductor memory devices, one known system has had the word drive circuits arranged on both sides of the memory cell arrays. While this system does allow the memory cell arrays to be miniaturized, it doubles the area occupied by the word drive circuits compared with a system where the word drive circuits are arranged on only one side of the memory cell array. Therefore, this known system run counter in principle to the miniaturization of semiconductor memory devices.

Summary of the invention

Accordingly, a primary object of the present invention is to provide a semiconductor memory device in which a memory cell array can be miniaturized without limitation by the word drive circuit.

Another object of the present invention is to provide a semiconductor memory device in which a memory cell array can be miniaturized without providing further word drive circuits.

In order to achieve the above objects, there is provided, according to the invention, a semiconductor memory device comprising: a plurality of word lines; a plurality of bit lines cross coupled with said word lines; a word-line selecting and driving circuit having inputs operatively receiving word address signals, said word-line selecting and driving circuit operatively decoding said word address signals and driving the selected word lines; a bit-line selecting circuit having inputs operatively receiving bit address signals, said bit-line selecting circuit operatively decoding said bit address signals and selecting one of said bit lines; and a plurality of memory cells arranged on intersections between said word lines and said bit lines; characterized in that; said word-line selecting and driving circuit has outputs each of which is commonly connected to a set of a plurality of adjacent word lines; and said memory cells are arranged only at intersections between one of the adjacent word lines in each one of said sets and one of said bit lines and between another of the adjacent word lines in said each of said sets and another of said bit lines.

Brief description of the drawings

The above objects and features as well as other features and advantages of the present invention will be more apparent when read in conjunction with the accompanying drawings, wherein:

Fig. 1 is a block diagram illustrating an example of a conventional semiconductor memory device;

Fig. 2 is a block diagram illustrating another example of a conventional semiconductor memory device;

Fig. 3 is a block diagram illustrating a semiconductor memory device, according to an embodiment of the present invention;

Fig. 4 is a circuit diagram illustrating a main portion of the semiconductor memory device of Fig. 3;

Fig. 5 is a plan view illustrating a pattern arrangement of a part of the memory cell array in the device of Fig. 3;

Fig. 6 is a cross-sectional view taken along line VI—VI of Fig. 5, illustrating a physical structure of a floating gate avalanche injection metal oxide semiconductor (FAMOS);

Fig. 7 is an expanded cross-sectional view taken along line VII—VII of Fig. 5, illustrating a physical structure of the FAMOS;

Fig. 8 is a plan view illustrating a pattern arrangement in which adjacent word lines are not commonly connected to an output of a word drive circuit; and

Fig. 9 is a block diagram illustrating a semiconductor memory device, according to another embodiment of the present invention.

Description of the preferred embodiments

Embodiments of the present invention will now be described in comparison with conventional technology and with reference to the accompanying drawings.

In Fig. 1, a conventional semiconductor memory device comprises a memory cell array MCA on which word lines $WL_1$ through $WL_5$ and bit lines $BL_1$ through $BL_5$ intersect each other. A memory cell MC is arranged on the intersection between each word line and bit line. The word lines $WL_1$ through $WL_5$ are connected, in a one-to-one correspondence, to the outputs of a word drive circuit WD including word drive units $WD_1$ through $WD_5$ respectively. The bit lines $BL_1$ through $BL_5$ are connected through a column gate CG to a sense amplifier SA. CD is a column decoder with outputs connected to the column gate CG. The column decoder CD and the column gate CG constitute a bit-line selecting circuit.

The miniaturization of memory cells due to recent developments in semiconductor technology has led to increasingly smaller intervals $d_1$ between adjacent word lines. However, since each word drive unit has a complicated circuit structure, the width $d_2$ of each word drive unit cannot be made as small as the smaller interval $d_1$. Since the word drive units $WD_1$ through $WD_5$ are integrated with the memory cell array on one chip, it is not practical to make the interval $d_1$ between word lines smaller than the width $d_2$ of each word drive unit. This is because it complicates the wiring patterns for connecting the word drive units $WD_1$ through $WD_5$ and the word lines $WL_1$ through $WL_5$. Thus, in the conventional device of Fig. 1, the miniaturization of a memory cell array is restricted by the width $d_2$ of the word drive unit.

In Fig. 2, another example of a conventional semiconductor memory device is illustrated. The main difference between Fig. 1 and Fig. 2 is that, in Fig. 2, in addition to the word drive circuit WD including the word drive units $WD_1$ through $WD_5$, additional word drive circuit WD′ including word drive units $WD_6$ through $WD_{10}$ are arranged on the side of the memory cell array MCA opposite to the word drive units $WD_1$ through $WD_5$. The outputs of the word drive units $WD_6$ through $WD_{10}$ are connected to additional word lines $WL_6$ through $WL_{10}$. Each of the additional word lines $WL_6$ through $WL_{10}$ extends between two adjacent word lines of the word lines $WL_1$ through $WL_5$. A memory cell MC is arranged on the intersection between each word line of the word lines $WL_1$ through $WL_{10}$ and each bit line of the bit lines $BL_1$ through $BL_5$. The circuit constitution of Fig. 2 is the same as that of Fig. 1 except for the above. Provision of word drive units on both sides of the memory cell array doubles the integration degree of the memory cell array in Fig. 2 over that of Fig. 1. However, it also doubles the area occupied by the word drive units over that of Fig. 1. Therefore, the conventional device of Fig. 2 runs counter in principle to the miniaturization of semiconductor memory devices.

An embodiment of the present invention will now be described with reference to Fig. 3. This embodiment is realized by an EPROM. In Fig. 3, the outputs $O_1$ through $O_5$ of the word drive units $WD_1$ through $WD_5$ are commonly connected to pairs of adjacent word lines ($WL_1$, $WL_2$), ($WL_3$, $WL_4$), ($WL_5$, $WL_6$), ($WL_7$, $WL_8$, and ($WL_9$, $WL_{10}$), respectively. Between each of the bit lines $BL_1$ through $BL_{10}$ and one of two word lines in each of the pairs ($WL_1$, $WL_2$) through ($WL_9$, $WL_{10}$), a memory cell MC is arranged. That is, between each of the bit lines $BL_1$, $BL_3$, $BL_5$, $BL_7$, and $BL_9$ and each of the word lines $WL_1$, $WL_4$, $WL_5$, $WL_8$, and $WL_9$, a memory cell MC is arranged. Also, between each of the bit lines $BL_2$, $BL_4$, $BL_6$, $BL_8$, and $BL_{10}$ and each of the word lines $WL_2$, $WL_3$, $WL_6$, $WL_7$, and $WL_{10}$, another memory cell MC is arranged. The bit lines $BL_1$ through $BL_{10}$ are connected to 10 outputs of a column gate $CG_0$. Ten inputs of the column gate $CG_0$ are connected to 10 outputs $C_1$, $C_2$, . . . of a column decoder $CD_0$. The column gate $CG_0$ is connected to a sense amplifier $SA_0$.

In operation, the word drive units receive word address signals and decode them to drive one of the five outputs $O_1$ through $O_5$, while, the column decoder $CD_0$ receives bit address signals and decodes them to select one of the outputs $C_1$ through $C_{10}$ to be a high potential. The selected one of the outputs $C_1$ through $C_{10}$ is applied to the corresponding gate transistor (not shown in Fig. 3) in the column gate $CG_0$ to open the gate transistor. Thus, the memory cell arranged between the driven word line and the selected bit line is selected for writing or reading.

In the wiring pattern of Fig. 3, the size of the memory cell array $MCA_0$ is the same the array MCA in Fig. 1 or Fig. 2. On the other hand, there are twice the number of word lines, bit lines, and memory cells as in Fig. 1. Therefore, the integration degree of the memory cell array $MCA_0$ in Fig. 3 is twice as that of the conventional array MCA in Fig. 1. It should be noted that the word drive units $WD_1$ through $WD_5$ are the same as those in the conventional example of Fig. 1. No additional word drive circuit is provided in Fig. 3.

It will be noted that the space between two adjacent bit lines in Fig. 3 is half that of Fig. 1. Since column gates are not as complex as word drive circuits and since the memory cells connected to one word line are connected to alternate bit lines, it is not a problem to reduce the space between adjacent bit lines.

Figure 4 is a circuit diagram illustrating a main portion of the semiconductor memory device of Fig. 3. In Fig. 4, the two word drive units $WD_1$ and $WD_2$, a part of the memory cell array $MCA_0$, connected to the word drive units $WD_1$ and $WD_2$, and a part of the column gate $CG_0$ connected to the part of the array $MCA_0$ are illustrated. The word drive unit $WD_1$ comprises a row decoder $RD_1$, an output buffer $B_1$, and a high voltage driving circuit $V_1$. The word drive unit $WD_2$ comprises a row decoder $RD_2$, an output buffer $B_2$, and a high voltage driving circuit $V_2$. Each of

these circuits in the word drive units is well known. Briefly, when all of word address signals $WA_1$ through $WA_n$ are "0", the output of the first row decoder $RD_1$ is selected. When all of word address signals $\overline{WA_1}$ and $WA_2$ through $WA_n$ are "0", that is, when the word address signals $WA_1$ through $WA_n$ are 1000...0, the output of the second row decoder $RD_2$ is selected.

The output buffer $B_1$ or $B_2$ receives an inverted power down signal $\overline{PD}$. When the memory device is in a standby state, the power down signal PD is at a high potential and the inverted power down signal $\overline{PD}$ is at a low potential so that the output buffers $B_1$ and $B_2$ are inactive.

The high voltage driving circuits $V_1$ and $V_2$ supply the high voltage $V_{pp}$ necessary to effect writing into the memory cells MC of the EPROM (PROM erasable by means of ultraviolet rays). During writing, a writing signal PGM* is applied to the gate of each enhancement-type load transistor, and an inverted writing signal $\overline{PGM}$ is applied to the gate of each depletion-type transfer transistor. When the output of the row decoder $RD_1$ is selected to be a high potential (H level), the output buffer $B_1$ outputs the H level. Therefore, the depletion-type transfer transistor in the selected high voltage driving circuit $V_1$ is cut off during writing, so that the high voltage $V_{pp}$ is applied to the output $O_1$ of the word drive unit $WD_1$. With respect to the remaining nonselected word drive circuits, for example, the word drive unit $WD_2$, since the output buffer $B_2$ outputs a low potential (L level), the depletion-type transfer transistor, having a threshold voltage of about $-2V$, is turned on, so that the output $O_2$ becomes the L level. During reading, the writing signal PGM* is not applied to the high voltage driving circuits, so that the high voltage $V_{pp}$ is not applied to the memory cells MC. No further detailed description is provided here because the constitutions of the word drive units $WD_1$, $WD_2$, ... are well known.

The memory cell array $MCA_0$ comprises memory cells MC. Each memory cell MC is a FAMOS with stored contents erasable by radiating ultraviolet rays. Each FAMOS has a control gate connected to a word line, a floating gate provided under the control gate and for storing information, a drain connected to a bit line, and a source connected to a ground. Each bit line is connected through a metal oxide semiconductor (MOS) transistor in the column gate $CG_0$ to the sense amplifier $SA_0$. The output signals $C_1$, $C_2$, $C_3$, ... of the column decoder $CD_0$ (Fig. 3) are applied to the gates of the MOS transistors in the column gate $CG_0$.

The output $O_1$ of the word drive unit $WD_1$ is commonly connected, in this embodiment, to two word lines $WL_1$ and $WL_2$. The output $O_2$ is similarly commonly connected to two word lines $WL_3$ and $WL_4$.

Figure 5 is a plan view illustrating a pattern arrangement of a part of the memory cell array in the device of Fig. 3. In Fig. 5, the word lines $WL_1$ and $WL_2$ extend in parallel at an interval $d_1$. At one end, the word lines $WL_1$ and $WL_2$ are connected to the output $O_1$ of the word drive unit $WD_1$ (Fig. 3). Similarly, the word lines $WL_3$ and $WL_4$ extend in parallel at the interval $d_1$ and are connected at one end to the output $O_2$ of the word drive unit $WD_2$. The interval between the word lines $WL_2$ and $WL_3$ is represented by $d_2$, which is greater than $d_1$ because of the presence of contact windows CW. The bit lines $BL_1$, $BL_2$, ... are arranged so as to be perpendicular to the extending direction of the word lines. Each memory cell MC, which is a well known FAMOS, is arranged on an intersecting portion of a word line and a bit line. The contact windows CW are for connecting the bit lines to diffusion regions D.

The physical structure of an FAMOS is illustrated in Fig. 6, which is a cross-sectional view taken along line VI—VI of Fig. 5. The physical structure of two or more FAMOS is illustrated in Fig. 7, which is a cross-sectional view taken along line VII—VII of Fig. 5. Referring to Figs. 5, 6, and 7, on a semiconductor substrate 1, a first insulating layer 2 is formed. On the first insulating layer 2, floating gates FG are formed. The word lines $WL_1$, $WL_2$, $WL_3$, ... are formed on the floating gates FG through a second insulating layer 3. The bit lines $BL_1$, $BL_2$, ... are formed on the floating gates FG through a third insulating layer 4. The word lines $WL_1$, $WL_2$, ... are formed by polycrystalline silicon and act as control gates. The bit lines $BL_1$, $BL_2$, ... are formed by an aluminum layer and are in contact with diffusion regions D. The diffusion regions D are formed by a self-alignment technique after forming the floating gates FG and the word lines (control gates) $WL_1$ and, therefore, are not present under the floating gates FG. The broken line in Fig. 7 indicates that the diffusion region D is not actually under the floating gate FG but is rather to its front or rear. It will be understood from Figs. 5 and 7 that the bit lines $BL_1$, $BL_2$, ... are in contact with the diffusion regions D at the contact windows CW.

As illustrated in Fig. 5, the interval between the two adjacent outputs $O_1$ and $O_2$ of the word drive circuits $WD_1$ and $WD_2$ is represented by $d_3$. The relation among the intervals $d_1$, $d_2$, and $d_3$ is $d_3=d_1+d_2$. Thus, the interval between adjacent word lines can be made smaller than the interval between adjacent outputs of the word drive circuits. Since $d_1$ is nearly equal to $d_2$, the interval between adjacent word lines can be reduced to about half the interval between adjacent outputs of the word drive circuit, i.e., half the width of a word drive unit.

If, as in the conventional device, adjacent word lines are not commonly connected to an output of a word drive circuit, and if the interval between word lines could be made as small as in Fig. 5, i.e., $d_1$ or $d_2$, as illustrated in Fig. 8, then the interval between adjacent outputs of the word drive circuit, i.e., the width of a word drive unit would have to be the same as the interval $d_1$ or $d_2$. However, as mentioned before, it is difficult to miniaturize the word drive circuit because each drive unit has a very complex structure, as shown in Fig. 4. Therefore, it is impossible to realize such a short interval between the adjacent outputs as $d_1$ or $d_2$ shown in Fig. 8.

It will be seen that, in the embodiment illustrated in Fig. 3, in addition to the number of word lines, the number of bit lines is also twice that in the conventional device. This means that the interval between adjacent bit lines is half that in the conventional device when the size of the memory cell array $MCA_0$ in Fig. 3 is the same as that of the array MCA in Fig. 1. It is not difficult to make the interval between adjacent bit lines shorter than in the conventional devices.

This is true especially in a memory cell used in an EPROM. The size of the memory cell in the EPROM has, as illustrated in Fig. 5, a width x and a length y. Because the floating gate FG extends along the extending direction of the word line (control gate), the length y is greater than the width x. In the conventional devices, the interval between adjacent bit lines was greater than the length y of the memory cell, as can be seen from Fig. 8. In the embodiment, the memory cells connected to one word line are connected to alternate bit lines. Also, the column gate $CG_0$ connected to the bit lines does not have as complex a circuit structure as the word drive circuit. Therefore, it is easy to shorten the interval between adjacent bit lines.

In the embodiment of Fig. 3, the number of memory cells is twice that of the conventional example of Fig. 1. On the other hand, the number of memory cells connected to each bit line is the same as that in the conventional example of Fig. 1. Therefore, when the number of memory cells in a memory device of the present invention is made the same as that of the conventional device, the number of memory cells connected to each bit line in the embodiment of the present invention can be reduced to less than that in the conventional example of Fig. 1. As a result, with respect to a certain memory capacity, the capacitance of each bit line in this embodiment, the capacitance being derived from the diffusion regions of memory cells connected to the bit line, is reduced to less than that the conventional example of Fig. 1. The reduction of the capacitance of each bit line results in an additional effect of high speed operation.

In the construction illustrated in Fig. 3, the number of the outputs $C_1$, $C_2$, . . ., and $C_{10}$ of the column decoder $CD_0$ is the same as the number of the bit lines $BL_1$, $BL_2$, . . ., and $BL_{10}$. Addition of a simple circuit in the column gate $CG_0$, however, can greatly reduce the number of the outputs of the column decoder. Figure 9 is a block diagram illustrating another embodiment of the present invention, in which the number of the outputs of the column decoder is reduced. In Fig. 9, the column decoder CD outputs seven signals, i.e., a first bit selection signal $BS_1$, a second bit selection signal $BS_2$, and the outputs $C_1$ through $C_5$. The column gate $CG_1$ comprises transistors $T_1$ through $T_5$, for respectively receiving the outputs $C_1$ through $C_5$, and transistors $Q_1$ through $Q_{10}$. The gates of the transistors $Q_1$ through $Q_5$ are adapted to receive the first bit selection signal $BS_1$. The gates of the transistors $Q_6$ through $Q_{10}$ are adapted to receive the second bit selection signal $BS_2$. The bit lines $BL_1$, $BL_3$, $BL_5$, $BL_7$, and $BL_9$ are respectively connected through the transistors $Q_1$, $Q_2$, $Q_3$, $Q_4$, and $Q_5$ to the transistors $T_1$, $T_2$, $T_3$, $T_4$, and $T_5$. The bit lines $BL_2$, $BL_4$, $BL_6$, $BL_8$, and $BL_{10}$ are respectively connected through the transistors $Q_6$, $Q_7$, $Q_8$, $Q_9$, and $Q_{10}$ to the transistors $T_1$, $T_2$, $T_3$, $T_4$, and $T_5$. The sources (or drains) of the transistors $T_1$, $T_2$, $T_3$, $T_4$, and $T_5$ are commonly connected to the input of the sense amplifier $SA_1$. The memory cell array $MCA_0$ and the word drive units $WD_1$ through $WD_5$ are the same as those in Fig. 3.

In the operation of the device of Fig. 9, when the first bit selection signal becomes the H level, the information on the bit lines $BL_1$, $BL_3$, $BL_5$, $BL_7$, and $BL_9$ is transferred to the transistors $T_1$ through $T_5$. When the second bit selection signal $BS_2$ becomes the H level, the information on the bit lines $BL_2$, $BL_4$, $BL_6$, $BL_8$, and $BL_{10}$ is transferred through the transistors $Q_6$, $Q_7$, $Q_8$, $Q_9$, and $Q_{10}$ to the transistors $T_1$ through $T_5$. According to the outputs $C_1$ through $C_5$ of the column decoder, the transistor selected from the transistor $T_1$ through $T_5$ transfers the information from the selected bit line to the sense amplifier $SA_1$.

In the constitution of Fig. 9, although there are 10 bit lines, there are seven outputs of the column decoder $CD_1$. Generally, n bit lines can be selected by $(n/2+2)$ outputs or $\{(n+1)/2+2\}$ outputs of the column decoder.

The present invention is not restricted to the above-described embodiments. Many other changes and modifications are possible without departing from the scope of the invention as defined in the claims.

For example, as an alternative to the EPROM erasable by means of ultraviolet rays, a mask read only memory (ROM) or a programmable read only memory (PROM) may be used for constituting a memory cell array. When a mask ROM or a PROM is used, the high voltage driving circuits $V_1$, $V_2$, . . . for effecting writing, included in the word drive circuit, are not necessary.

Also, instead of connecting two adjacent word lines to one output of a word drive circuit, a set including three or more adjacent word lines may alternatively be connected to one output of a word drive circuit.

From the foregoing description, it will be apparent that, according to the present invention, in a semiconductor memory device, a memory cell array can be miniaturized regardless of the fact that the word drive circuit cannot be miniaturized and without providing a further word drive circuit. Also, with respect to a certain memory capacity, the number of memory cells connected to one bit line is reduced in comparison with the prior art so that the capacity of the bit line is reduced, resulting in a high speed operation.

## Claims

1. A semiconductor memory device comprising:

a plurality of word lines;

a plurality of bit lines cross coupled with said word lines;

a word-line selecting and driving circuit having inputs operatively receiving word address signals, said word-line selecting and driving circuit operatively decoding said word address signals and driving the selected word lines;

a bit-line selecting circuit having inputs operatively receiving bit address signals, said bit-line selecting circuit operatively decoding said bit address signals and selecting one of said bit lines; and

a plurality of memory cells arranged at intersections between said word lines and said bit lines; characterized in that:

said word-line selecting and driving circuit has outputs each of which is commonly connected to a set of a plurality of adjacent word lines;

said memory cells are arranged only at intersections between one of the adjacent word lines in each one of said sets and one of said bit lines and between another of the adjacent word lines in said each one of said sets and another of said bit lines.

2. A semiconductor memory device as set forth in claim 1, wherein the interval between adjacent bit lines is shorter than the length of the memory cell in the word line extending direction.

3. A semiconductor memory device as set forth in claim 2, wherein, in each set of said plurality of adjacent word lines, said memory cells are arranged in such a manner that a first memory cell is arranged at the intersection between a first word line and a first bit line; a second memory cell is arranged at the intersection between a second word line adjacent to said first word line and a second bit line adjacent to said first bit line; a third memory cell is arranged at the intersection between a third word line adjacent to said second word line and a third bit line adjacent to said second bit line; and so on.

4. A semiconductor memory device as set forth in claim 3, wherein said bit-line selecting circuit comprises a column decoder ($CD_1$) for decoding said bit address signals and a column gate ($CG_1$) for selecting one of said bit lines to transfer information on said selected bit line to a sense amplifier, said column decoder ($CD_1$) being adapted to output a bit-line selecting signal ($BS_1$, $BS_2$), said column gate comprising a plurality of groups of transfer gates ($Q_1$ through $Q_5$, $Q_6$ through $Q_{10}$), connected to said bit lines in a one-to-one correspondence, and a plurality of bit-line selecting transistors ($T_1$ through $T_5$), connected to said transfer gates in each group, said transfer gates in each group being adapted to simultaneously transfer information on the bit lines connected to said transfer gates in said group when said group receives said bit-line selecting signal, and said column decoder being adapted to output a decoder signal so as to select one of said bit-line selecting transistors to transfer information from said transfer gate connected to the selected bit-line selecting transistor to said sense amplifier.

5. A semiconductor memory device as set forth in claim 3 or 4, wherein two adjacent word lines are commonly connected to one output of said word-line selecting and driving circuit.

6. A semiconductor memory device as set forth in any one of claims 1 through 4, wherein said semiconductor memory device is an EPROM, and said memory cells are FAMOS memory cells.

7. A semiconductor memory device as set forth in claim 5, wherein said semiconductor memory device is an EPROM, and said memory cells are FAMOS memory cells.

8. A semiconductor memory device as set forth in any one of claims 1 through 4, wherein said semiconductor memory device is a mask ROM.

9. A semiconductor memory device as set forth in claim 5, wherein said semiconductor memory device is a mask ROM.

10. A semiconductor memory device as set forth in any one of claims 1 through 4, wherein said semiconductor memory device is a PROM.

11. A semiconductor memory device as set forth in claim 5, wherein said semiconductor memory device is a PROM.

## Patentansprüche

1. Halbleiterspeichervorrichtung mit:

einer Vielzahl von Wortleitungen;

einer Vielzahl von Bitleitungen, die quer zu den Wortleitungen angeschlossen sind;

einer Wortleitungsauswahl- und Treiberschaltung, deren Eingänge im Betrieb Wortadressensignale empfangen, wobei die genannte Wortleitungsauswahl- und Treiberschaltung im Betrieb die genannten Wortadressensignale decodiert und die ausgewählten Wortleitungen treibt;

einer Bitleitungsauswahlschaltung, deren Eingänge im Betrieb die Bitadressensignale empfangen, wobei die genannte Bitleitungsauswahlschaltung im Betrieb die genannten Bitadressensignale decodiert und eine der genannten Bitleitungen auswählt; und

einer Vielzahl von Speicherzellen, die an Kreuzungspunkten zwischen den genannten Wortleitungen und den genannten Bitleitungen angeordnet sind;

dadurch gekennzeichnet, daß:

die genannte Wortleitungsauswahl- und Treiberschaltung Ausgänge hat, von denen jeder gemeinsam mit einem Satz einer Vielzahl von benachbarten Wortleitungen verbunden ist;

die genannten Speicherzellen lediglich an den Kreuzungsstellen zwischen einer der benachbarten Wortleitungen in jedem der genannten Sätze und einer der genannten Bitleitungen und zwischen einer anderen der benachbarten Wortleitungen in jedem der genannten Sätze und einer anderen der genannten Bitleitungen angeordnet sind.

2. Halbleiterspeichervorrichtung nach Anspruch 1, bei welcher das Intervall zwischen benachbarten Bitleitungen kürzer als die Länge der Speicherzelle in der Erstreckungsrichtung der Wortleitung ist.

3. Halbleiterspeichervorrichtung nach Anspruch 2, bei welcher, in jedem Satz der genannten Vielzahl von benachbarten Wortleitungen, die genannten Speicherzellen so angeordnet sind, daß eine erste Speicherzelle an dem Schnittpunkt zwischen einer ersten Wortleitung und einer ersten Bitleitung angeordnet ist; eine zweite Speicherzelle ist an dem Schnittpunkt zwischen einer zweiten Wortleitung neben der genannten ersten Wortleitung und einer zweiten Bitleitung neben der genannten ersten Bitleitung angeordnet; eine dritte Speicherzelle ist an dem Schnittpunkt zwischen einer dritten Wortleitung neben der genannten zweiten Wortleitung und einer dritten Bitleitung neben der genannten zweiten Bitleitung angeordnet; usw.

4. Halbleiterspeichervorrichtung nach Anspruch 3, bei welcher die genannte Bitleitungsauswahlschaltung einen Spaltendecoder ($CD_1$) zum Decodieren der genannten Bitadressensignale und ein Spaltengatter ($CG_1$) zum Auswählen einer der genannten Bitleitungen umfaßt, um Information auf der genannten Bitleitung zu einem Leseverstärker zu übertragen, wobei der Spaltendecoder ($CD_1$) zur Ausgabe eines Bitleitungsauswahlsignals ($BS_1$, $BS_2$) adaptiert ist, das Spaltengatter eine Vielzahl von Gruppen von Transfergates ($Q_1$ bis $Q_5$, $Q_6$ bis $Q_{10}$) umfaßt, die mit den genannten Bitleitungen in einer Eins-zueins-Korrespondenz angeschlossen sind, und eine Veilzahl von Bitleitungsauswahltransistoren ($T_1$ bis $T_5$), die mit den genannten Transfergates in jeder Gruppe verbunden sind, wobei die Transfergates in jeder Gruppe adaptiert sind, um gleichzeitig Information auf den Bitleitungen zu übertragen, die mit den genannten Transfergates in der genannten Gruppe verbunden sind, wenn die genannte Gruppe das Bitleitungsauswahlsignal empfängt, und die genannten Spaltendecoder so adaptiert sind, daß sie ein Decodersignal ausgeben, um so einen der genannten Bitleitungsauswahltransistoren auszuwählen, um Information von dem genannten Transfergate, das mit dem ausgewählten Bitleitungswahltransistor verbunden ist, zu dem genannten Leseverstärker zu übertragen.

5. Halbleiterspeichervorrichtung nach Anspruch 3 oder 4, bei welcher zwei benachbarte Wortleitungen gemeinsam mit einem Ausgang der genannten Wortleitungsauswahl- und Treiberschaltung verbunden sind.

6. Halbleiterspeichervorrichtung nach einem der Ansprüche 1 bis 4, bei welcher die genannte Halbleiterspeichervorrichtung ein EPROM ist und die genannten Speicherzellen FAMOS-Speicherzellen sind.

7. Halbleiterspeichervorrichtung nach Anspruch 5, bei welcher die genannte Halbleiterspeichervorrichtung ein EPROM und die genannten Speicherzellen FAMOS-Speicherzellen sind.

8. Halbleiterspeichervorrichtung nach einem der Ansprüche 1 bis 4, bei welcher die genannte Halbleiterspeichervorrichtung ein Masken-ROM ist.

9. Halbleiterspeichervorrichtung nach Anspruch 5, bei welcher die genannte Halbleiterspeichervorrichtung ein Masken-ROM ist.

10. Halbleiterspeichervorrichtung nach einem der Ansprüche 1 bis 4, bei welcher die genannte Halbleiterspeichervorrichtung ein PROM ist.

11. Halbleiterspeichervorrichtung nach Anspruch 5, bei welcher die genannte Halbleiterspeichervorrichtung ein PROM ist.

**Revendications**

1. Dispositif de mémoire à semiconducteur, comprenant:

plusieurs lignes de mot;

plusieurs lignes de bit couplées en croix avec lesdites lignes de mot;

un circuit de sélection et d'excitation de ligne de mot possédant des entrées qui reçoivent fonctionnellement des signaux d'adresse de mot, ledit circuit de sélection et d'excitation de ligne de mot ayant pour fonction de décoder lesdits signaux d'adresse de mot et d'exciter les lignes de mot sélectionnées;

un circuit de sélection de ligne de bit possédant des entrées qui reçoivent fonctionnellement des signaux d'adresse de bit, ledit circuit de sélection de ligne de bit ayant pour fonction de décoder lesdits signaux d'adresse de ligne de bit et de sélectionner l'une desdites lignes de bit; et

plusieurs cellules de mémoire disposées en des intersections desdites lignes de mot et desdites lignes de bit;

caractérisé en ce que:

ledit circuit de sélection et d'excitation de ligne de mot possède des sorties dont chacune est connectée en commun à un groupe de plusieurs lignes de mot adjacentes;

lesdites cellules de mémoire ne sont disposées qu'en des intersections entre une des lignes de mot adjacentes de chacun desdits groupes et une desdites lignes de bit et entre une autre des lignes de mot adjacentes de chacun desdits groupes et une autre desdites lignes de bit.

2. Dispositif de mémoire à semiconducteur selon la revendication 1, où l'intervalle entre lignes de bit adjacentes est plus court que la longueur de la cellule de mémoire dans la direction des lignes de mot.

3. Dispositif de mémoire à semiconducteur selon la revendication 2, où, dans chaque groupe desdites lignes de mot adjacentes, lesdites cellules de mémoire sont disposées de telle manière qu'une première cellule de mémoire se trouve à l'intersection entre une première ligne de mot et une première ligne de bit; une deuxième cellule de mémoire se trouve à l'intersection entre une deuxième ligne de mot, adjacentes à ladite première ligne de mot, et une deuxième ligne de bit, adjacente à ladite première ligne de bit; une troisième cellule de mémoire se trouve à l'intersection entre une troisième ligne de mot adjacente à ladite deuxième ligne de mot et une troisième ligne de bit adjacente à ladite deuxième ligne de bit; et ainsi de suite.

4. Dispositif de mémoire semiconducteur selon la revendication 3, où ledit circuit de sélection de ligne de bit comprend un décodeur de colonne ($CD_1$) servant à décoder lesdits signaux d'adresse de bit et une porte de colonne ($CG_1$) servant à sélectionner une desdites lignes de bit afin de transférer l'information se trouvant sur ladite ligne de bit sélectionnée à un amplificateur de lecture, ledit décodeur de colonne ($CD_1$) étant conçu pour délivrer un signal de sélection de ligne de bit ($BS_1$, $BS_2$), ladite porte de colonne comprenant plusieurs groupes de porte de transfert ($Q_1$ à $Q_5$, $Q_6$ à $Q_{10}$), connectées auxdites lignes de bit selon une correspondance biunivoque, et plusieurs transistors de sélection de lignes de bit ($I_1$ à $T_5$), connectés auxdites portes de transfert de chaque groupe, lesdites portes de transfert de chaque groupe étant destinées à transférer simultanément l'information se trouvant sur les lignes de bit connectées auxdites portes de transfert dudit groupe lorsque ledit groupe reçoit ledit signal de sélection de ligne de bit, et ledit décodeur de colonne étant destiné à délivrer un signal de décodeur afin de sélectionner l'un desdits transistors de sélection de ligne de bit pour qu'il transfère l'information de ladite porte de transfert connectée avec le transistor de sélection de ligne de bit sélectionné audit amplificateur de lecture.

5. Dispositif de mémoire à semiconducteur selon la revendication 3 ou 4, où deux lignes de mot adjacentes sont connectées en commun à une sortie du circuit de sélection et d'excitation de ligne de mot.

6. Dispositif de mémoire à semiconducteur selon l'une quelconque des revendications 1 à 4, où le dispositif de mémoire à semiconducteur est une EPROM, et lesdites cellules de mémoire sont des cellules de mémoire FAMOS.

7. Dispositif de mémoire à semiconducteur selon la revendication 5, où ledit dispositif de mémoire à semiconducteur est une EPROM, et lesdites cellules de mémoire sont des cellules de mémoire FAMOS.

8. Dispositif de mémoire à semiconducteur selon l'une quelconque des revendications 1 à 4, où ledit dispositif de mémoire à semiconducteur est une ROM à masque.

9. Dispositif de mémoire à semiconducteur selon la revendication 5, où ledit dispositif de mémoire à semiconducteur est une ROM à masque.

10. Dispositif de mémoire à semiconducteur selon l'une quelconque des revendications 1 à 4, où ledit dispositif de mémoire à semiconducteur est une PROM.

11. Dispositif de mémoire semiconducteur selon la revendication 5, où ledit dispositif de mémoire à semiconducteur est une PROM.

Fig. 1

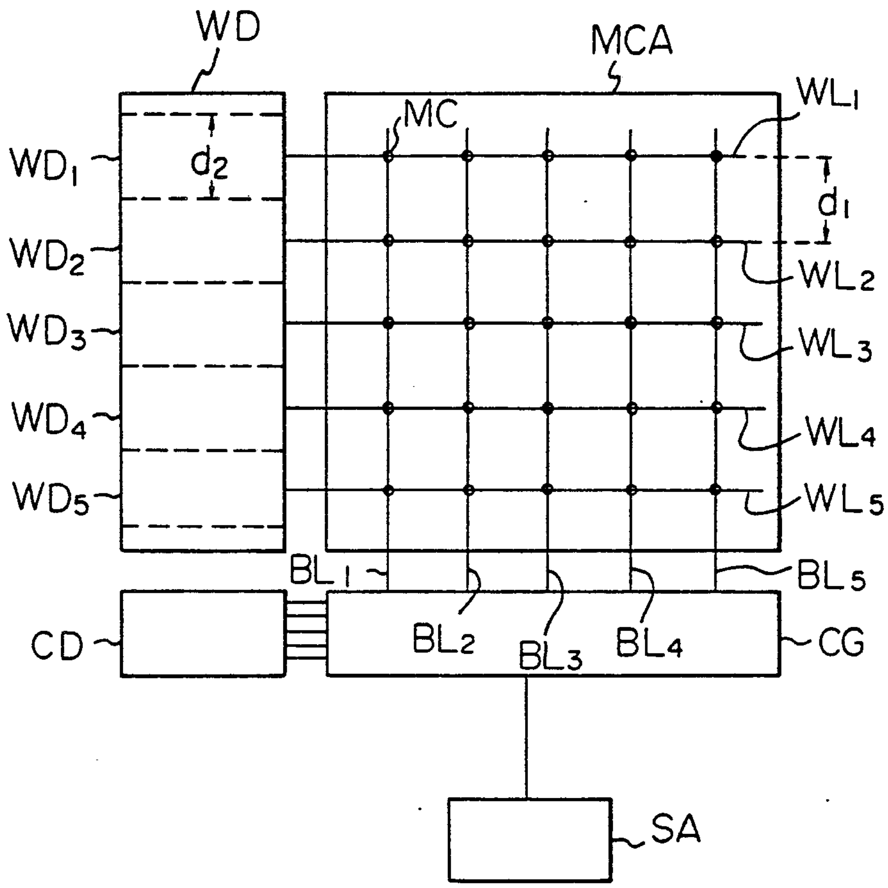
WD
MCA
MC
WL1
WD1
d2
d1
WD2
WL2
WD3
WL3
WD4
WL4
WD5
WL5
BL1
BL5
BL2
BL3
BL4
CD
CG
SA

Fig. 2

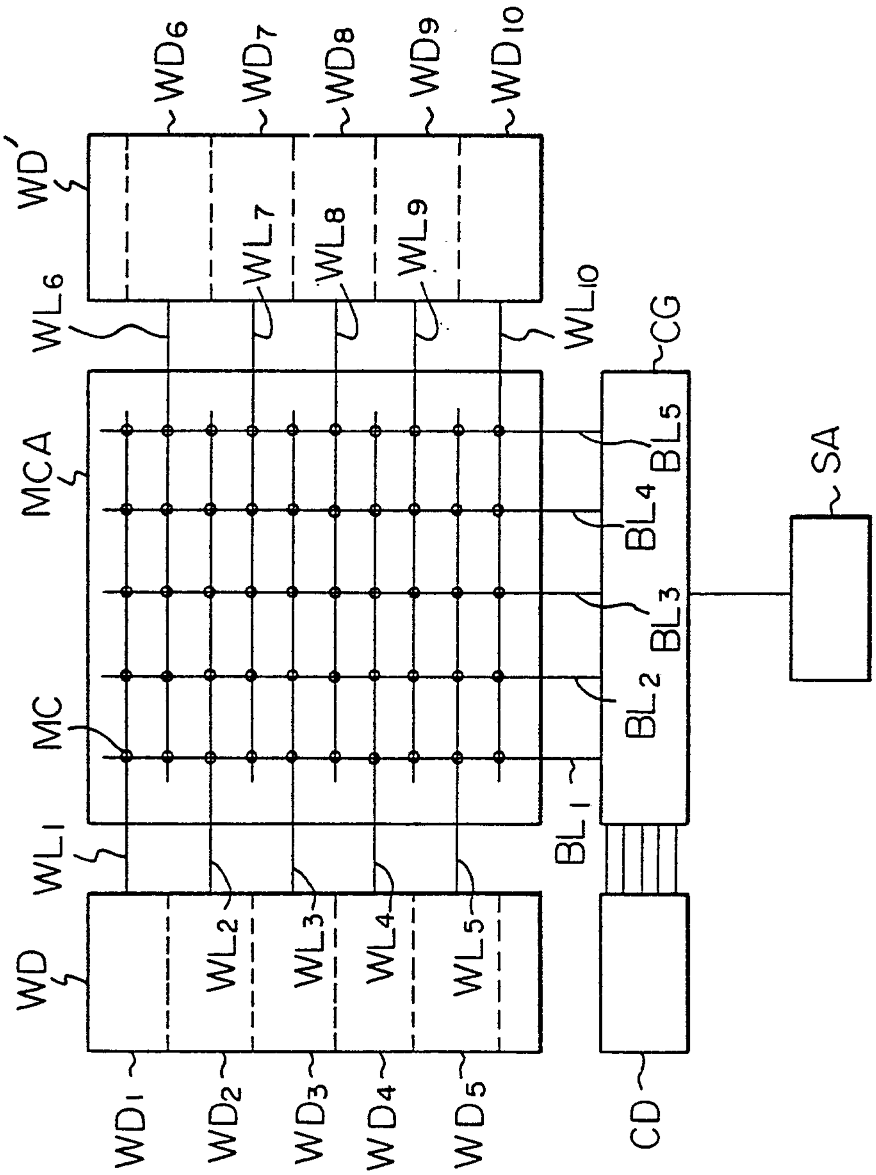
WD6
WD7
WD8
WD9
WD10
WD'
WL6
WL7
WL8
WL9
WL10
CG
MCA
MC
SA
BL1
BL2
BL3
BL4
BL5
WL1
WL2
WL3
WL4
WL5
WD
WD1
WD2
WD3
WD4
WD5
CD

Fig. 3

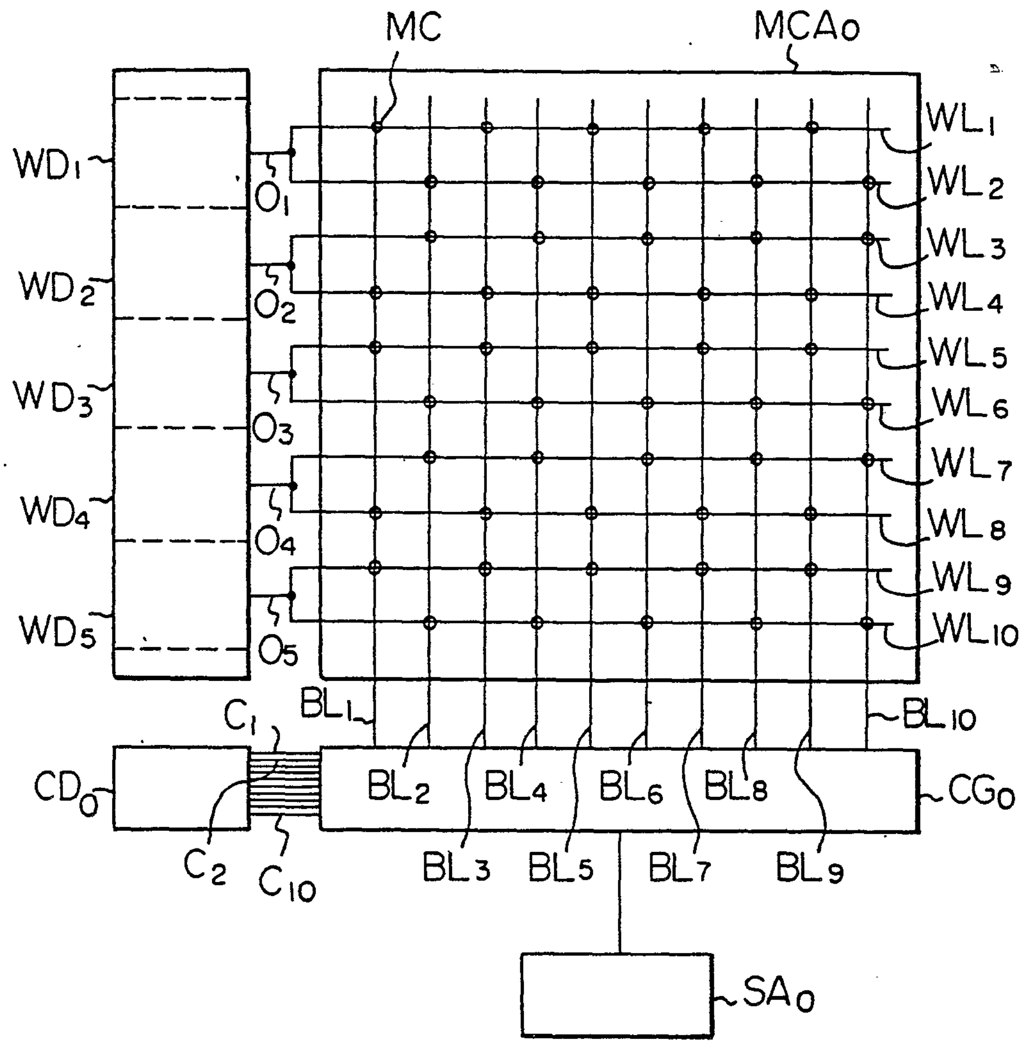
MC
MCA0
WD1
WD2
WD3
WD4
WD5
O1
O2
O3
O4
O5
WL1
WL2
WL3
WL4
WL5
WL6
WL7
WL8
WL9
WL10
BL1
BL10
C1
C2
C10
CD0
BL2
BL4
BL6
BL8
BL3
BL5
BL7
BL9
CG0
SA0

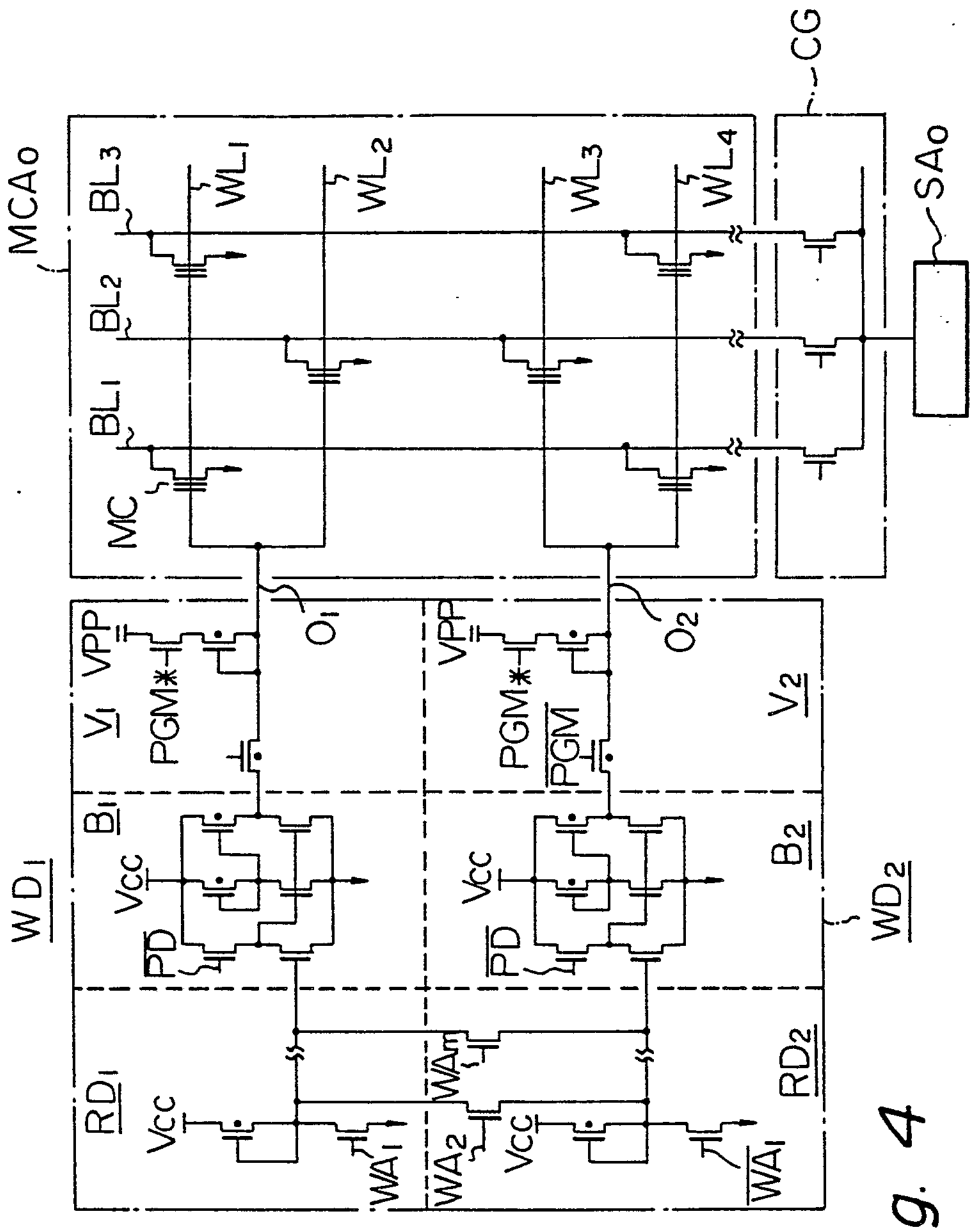
MCAo
CG
BL3
BL2
BL1
WL1
WL2
WL3
WL4
MC
SAo
O1
O2
VPP
PGM*
PGM
V1
V2
B1
B2
WD1
WD2
Vcc
PD
RD1
RD2
WA1
WA2
WAm

Fig. 4

Fig. 5

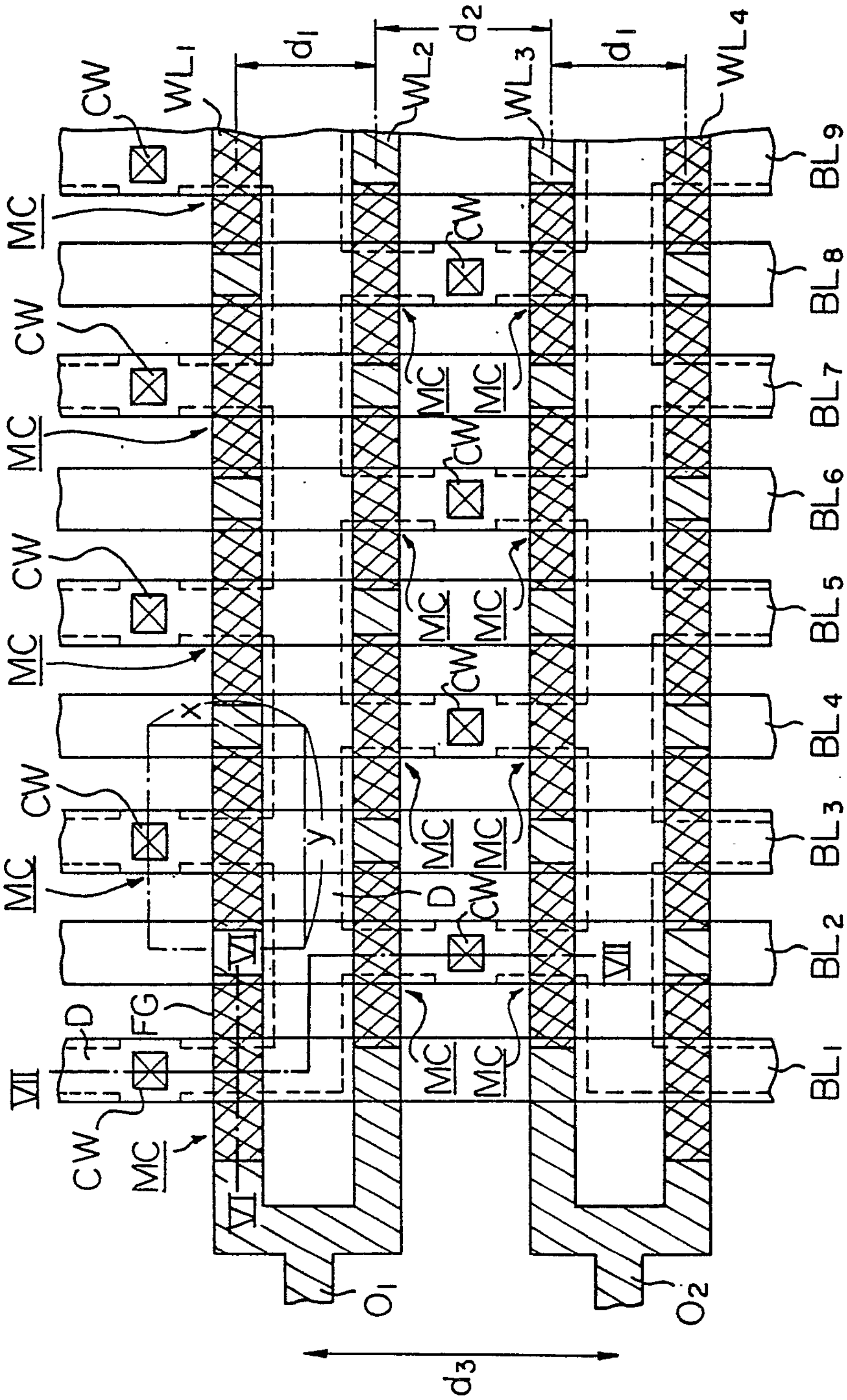
CW
MC
WL$_1$
WL$_2$
WL$_3$
WL$_4$
d$_1$
d$_2$
d$_3$
BL$_1$
BL$_2$
BL$_3$
BL$_4$
BL$_5$
BL$_6$
BL$_7$
BL$_8$
BL$_9$
D
FG
VI
VII
x
y
O$_1$
O$_2$

Fig. 6

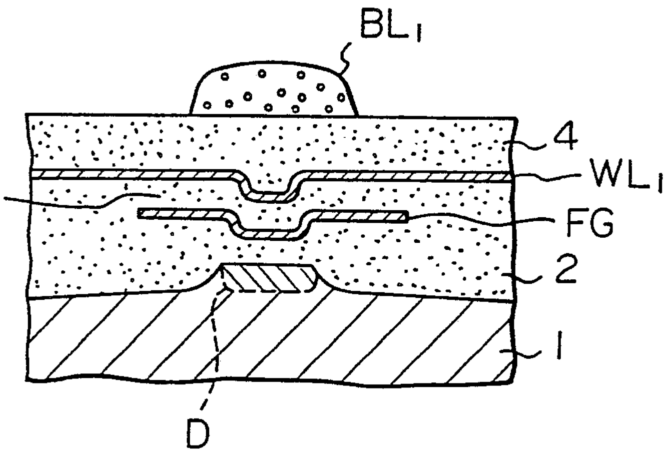
BL1
4
WL1
3
FG
2
1
D

Fig. 7

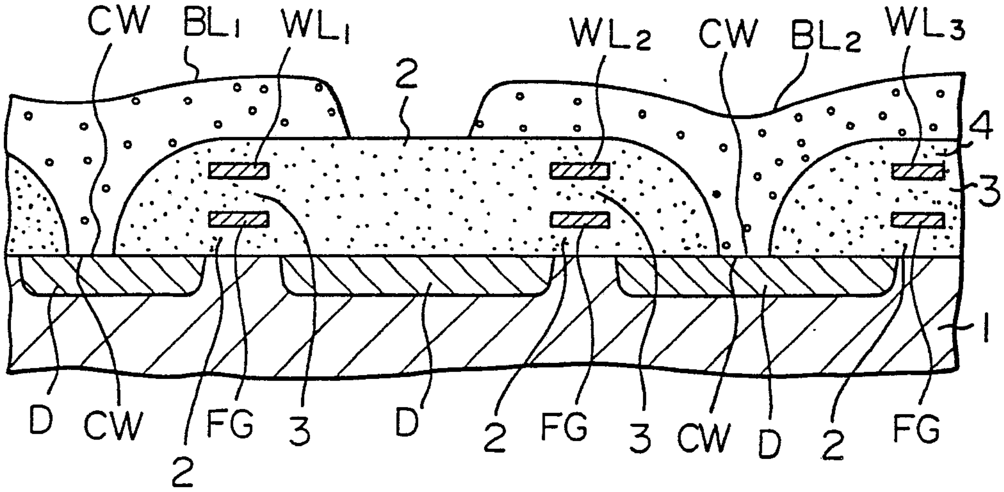
CW
BL1
WL1
2
WL2
CW
BL2
WL3
4
3
1
D
CW
2
FG
3
D
2
FG
3
CW
D
2
FG
2

Fig. 8

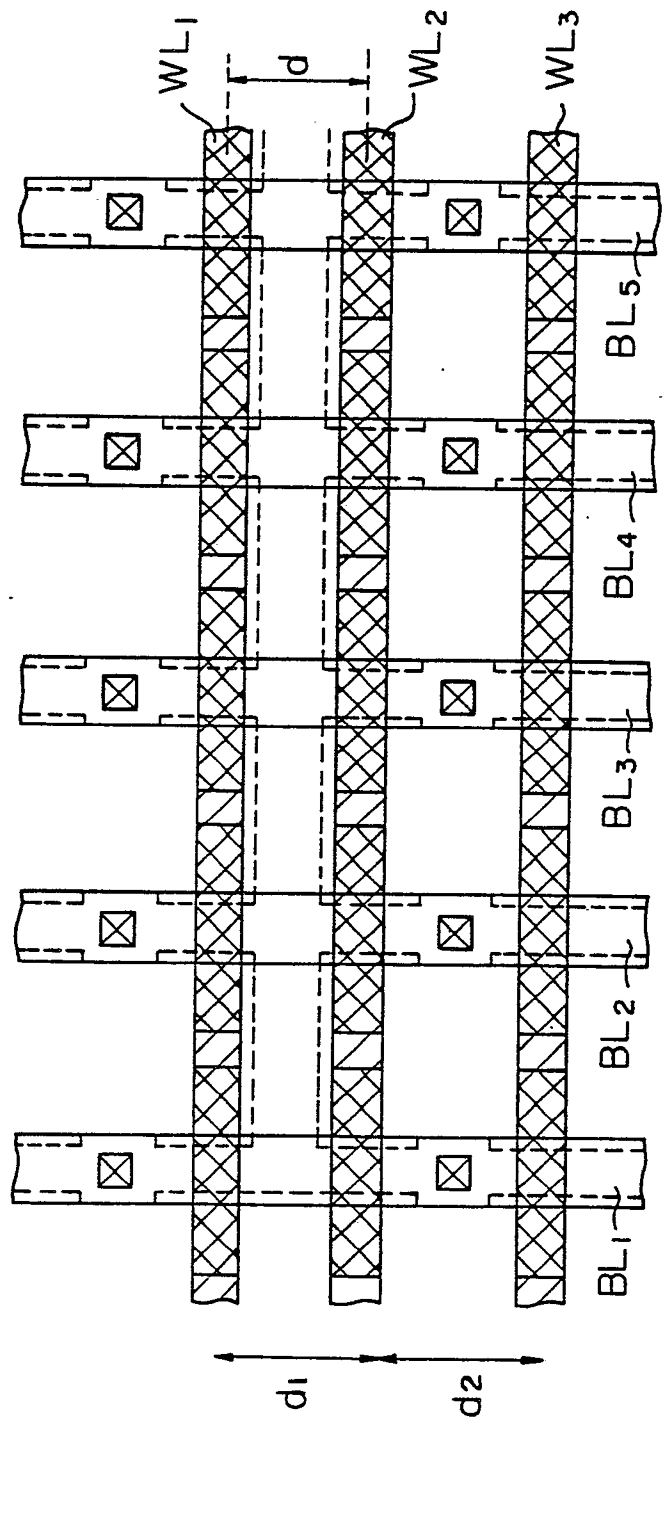

Fig. 9

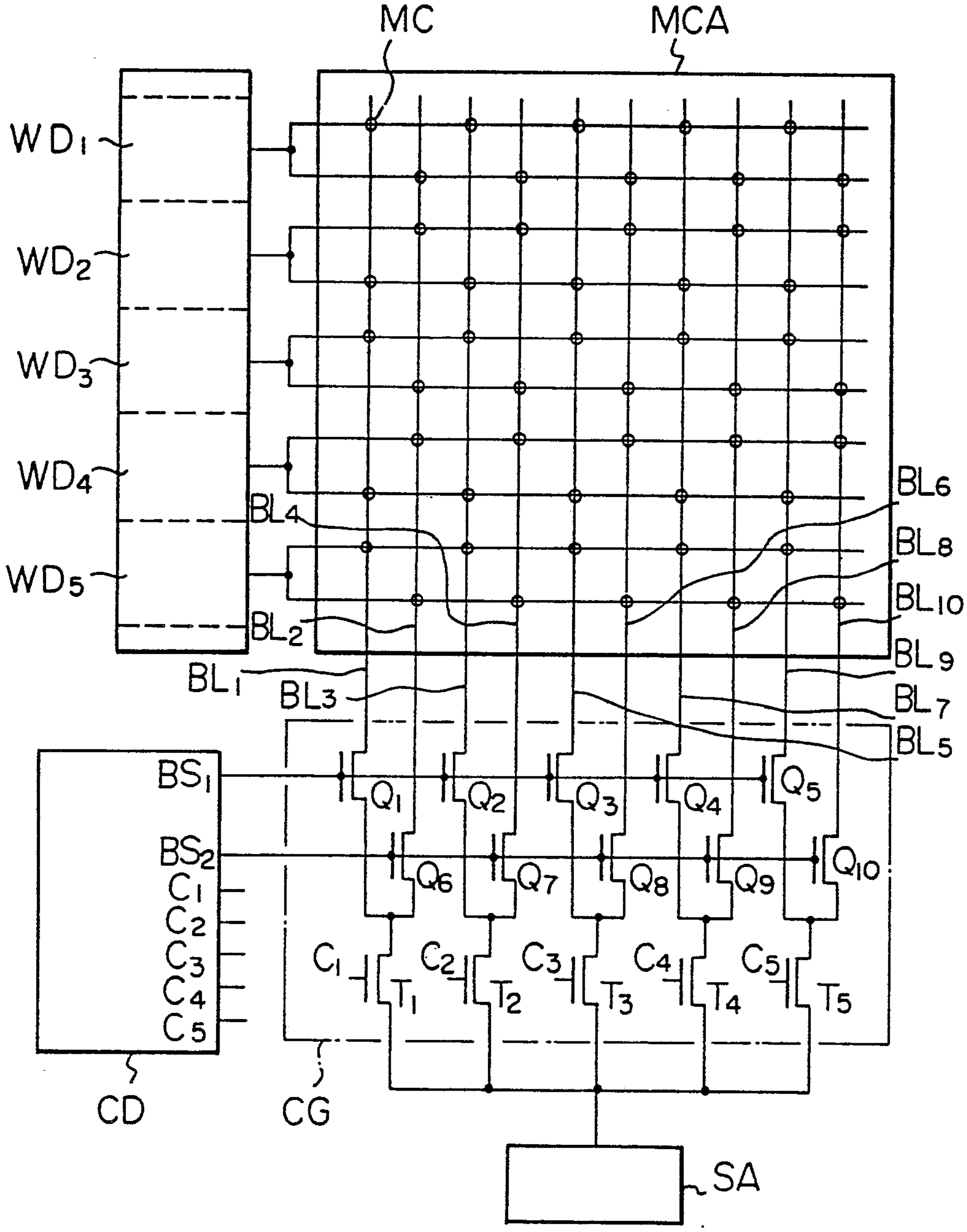
MC
MCA
WD1
WD2
WD3
WD4
WD5
BL4
BL2
BL1
BL3
BL6
BL8
BL10
BL9
BL7
BL5
BS1
BS2
C1
C2
C3
C4
C5
Q1
Q2
Q3
Q4
Q5
Q6
Q7
Q8
Q9
Q10
T1
T2
T3
T4
T5
CD
CG
SA